# EUROPÄISCHE PATENTSCHRIFT

(11) **EP 0 262 346 B1**
(45) Veröffentlichungstag und Bekanntmachung des Hinweises auf die Patenterteilung: **31.03.1993**
(21) Anmeldenummer: 87111422.9
(22) Anmeldetag: 07.08.1987
(51) Int. Cl.: H01L 29/90, H01L 29/165, H01L 29/161

(54) **IMPATT-Diode**
IMPATT diode
Diode IMPATT

(30) Priorität: 27.09.1986 DE 3632921; 30.07.1987 DE 3725214
(43) Veröffentlichungstag der Anmeldung: 06.04.1988
(73) Patentinhaber: Licentia Patent-Verwaltungs-GmbH, 60596 Frankfurt (DE)
(72) Erfinder: Jorke, Helmut, Dipl.Phys., D-7929 Gerstetten (DE); Luy, Johann-Friedrich, Dipl.-Ing., D-7900 Ulm (DE)
(74) Vertreter: Amersbach, Werner, Dipl.-Ing.

(56) Entgegenhaltungen:
- FR-A- 2 225 842
- US-A- 3 466 312
- US-A- 4 291 320
- US-A- 4 529 455
- APPLIED PHYSICS LETTERS, Band 47, Nr. 12, Dezember 1985, Seiten 1333-1335, Woodbury, New York, US; D.V. LANG et al.: "Measurement of the band gap of GexSi1-x/Si strained-layer heterostructures"
- PHYSICAL REVIEW B, Band 32, Nr. 2, 15. Juli 1985, Seiten 1405-1408, The American Physical Society, New York, US; R. PEOPLE: "Indirect band gap of coherently strained GexSi1-x bulk alloys on [001] silicon substrates"
- SOLID STATE TECHNOLOGY, Band 28, Nr. 10, Oktober 1985, Seiten 137-143, Port Washington, New York, US; K.L. WANG: "Novel devices by Si-based molecular beam epitaxy"
- PROCEEDINGS OF THE IEEE, Band 61, Nr. 5, Mai 1973, Seiten 666-667, IEEE, New York, US; D.H. LEE: "Low-frequency noise of ion-implanted double-drift IMPATT diodes"
- K. Seeger, "Semiconductor Physics An Introduction" 2. Auflage (Springer-Verlag, Berlin 1982), Seiten 10-13

## Beschreibung

Die Erfindung betrifft eine IMPATT-Diode nach dem Oberbegriff des Patentanspruchs 1.

IMPATT-Dioden sind leistungsfähige Millimeterwellenbauelemente. Sie werden insbesondere zur Erzeugung von Schwingungen benützt.

Die Lawinenvervielfachung durch Stoßionisation und die Bewegung der Ladungsträger durch einen Laufraum können zusammen einen negativen Widerstand ergeben. Eine zur Erzeugung und Kombination dieser Mechanismen geeignete Struktur ist z.B. ein p-n-Übergang.

Durch die Benutzung eines Heteroüberganges anstatt eines p-n-Überganges läßt sich die erforderliche Spannung für den Lawinendurchbruch der IMPATT-Diode reduzieren. Die Heterostruktur der IMPATT-Diode muß so aufgebaut sein, daß das Halbleitermaterial der Generationszone (Lawinendurchbruchzone) eine kleineren Bandabstand besitzt als das der Driftzone. Dadurch wird die Ionisationsschwellenenergie erniedrigt und damit der Wirkungsgrad der IMPATT-Diode erhöht. Eine IMPATT-Diode mit Heterostruktur deren Generationszone durch eine Einzelschicht aus einem Halbleitermaterial mit geringem Bandabstand und deren Driftzone aus einem Halbleitermaterial mit größerem Bandabstand gebildet wird, ist aus der US-PS 3,466,512 bekannt. Als mögliche Kombinationen von Halbleitermaterialien sind u.a. Ge für die Generationszone und Si für die Driftzone angegeben.

Die vorbekannten Lösungen haben jedoch den Nachteil, daß durch die verwendeten Halbleitermaterialien der Wirkungsgrad der IMPATT-Diode für z.B. eine Frequenz von 80GHz unter 10% liegt und der Wellenlängenbereich auf den mm-Bereich beschränkt ist. Außerdem ist die Verwendung von kostengünstigen Si-Substraten nur eingeschränkt möglich.

Weiterhin sind aus der Literatur Si-SiGe Heterostrukturen bekannt, die auf Si-Substrate frei von Gitterfehlanpassungen aufgewachsen werden können, wenn die SiGe-Schichten genügend dünn aufgewachsen werden. Bei derartigen verspannten SiGe-Schichten eines undotierten Si/SiGe-Übergitters wird eine merkliche Erniedrigung der Bandlücke gegenüber undotierten , spannungsfreien SiGe-Schichten festgestellt. (Lang et al.: Applied Physics Letters 47 (12), S. 1333 (1985).

Der Erfindung liegt die Aufgabe zugrunde, eine IMPATT-Diode mit Heterostruktur anzugeben, die kostengünstig herstellbar ist, die einen hohen Wirkungsgrad besitzt und deren Wellenlängenbereich den mm- und sub-mm-Bereich umfaßt.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Die Erfindung hat den Vorteil, daß die IMPATT-Diode mit einem kostengünstigen Si-Substrat hergestellt ist und ihr Wirkungsgrad durch eine geeignete Si/SiGe-Heterostruktur verbessert wird.

Die Erfindung wird im folgenden anhand von Ausführungsbeispielen näher erläutert unter Bezugnahme auf schematische Zeichnungen.
- FIG. 1: zeigt den Aufbau einer Einfach-Heterostruktur IMPATT-Diode.
- FIG.2: zeigt den Aufbau einer Doppel-Heterostruktur-IMPATT-Diode.
- FIG: 3: zeigt das Energiebandschema für ein Si/Si_{O,2}Ge_{0,8}-Übergitter.

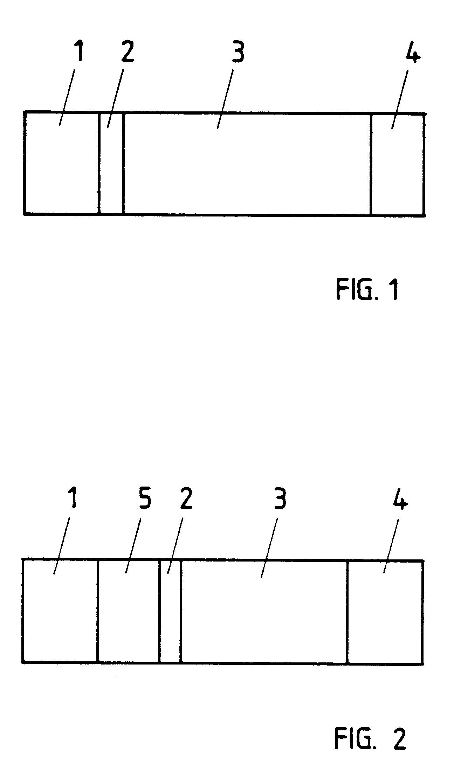

Gemäß FIG. 1 ist auf einem p⁺-dotierten Si-Substrat 1 mit einer Ladungsträgerkonzentration von mehr als 10¹⁹ cm⁻³ eine Halbleiterschichtenfolge aus
- einem undotierten Si/Si₁₋ₓGeₓ-Übergitter 2 mit einer Schichtdicke von ungefähr 0,02µm,
- einer n-dotierten Si-Schicht 3 mit einer Ladungsträgerkonezntration von ungefähr 1,4 . 10¹⁷ cm⁻³ und einer Schichtdicke von etwa 0,3µm,
- einer n⁺-dotierten Si-Schicht mit einer Ladungsträgerkonzentration von ungefähr 5 ^{.} 10¹⁹ cm⁻³ und einer Schichtdicke von etwa 0,1µm
aufgebracht.

Die Bezeichnung "+" bedeutet starke Dotierung. Dotiermaterialien für die n-Dotierung sind z.B. Sb, P, As und für die p-Dotierung B, Ga,Al, In.

An die Struktur gemäß FIG. 1 wird eine so hohe Sperrspannung angelegt, daß sich die Sperrschicht über die Halbleiterschichten 2, 3 erstreckt. An der Grenze zwischen p⁺-dotiertem Si-Substrat 1 und Si/Si₁₋ₓGeₓ-Übergitter 2 ist die maximale Feldstärke so groß, daß Stoßionisation einsetzt.

Der Halbleiterschichtenaufbau einer IMPATT-Diode gemäß FIG. 1 unterscheidet sich von einer IMPATT-Diode auf Si-Basis mit p-n-Übergang dadurch daß ein Si/Si₁₋ₓGeₓ-Übergitter 2 an der Stelle aufgewachsen ist, an der die zur Stoßionisation und damit die zur Lawinenmultiplikation erforderliche Feldstärke auftritt.

SiGe besitzt einen kleiner Bandabstand E_{g} als Si (E_{g} = 1,12eV) und damit eine niedrigere Ionisationsschwellenenergie als Si. Für eine 0,02µm dicke Si_{O,6}Ge_{0,4}-Schicht beträgt der Bandabstand E_{g} = 0,76eV. Weiterhin wird durch die unterschiedlichen Gitterkonstanten von Si und SiGe eine laterale mechanische Spannung in den Halbleiterschichten erzeugt. Wird z.B. auf einem Si-Substrat 1 eine Si_{0,6}Ge_{0,4}-Schicht 2 mit einer unterkritischen Schichtdicke von etwa 0,02µm abgeschieden, so entsteht in der SiGe-Schicht eine laterale Druckspannung, da die natürliche Gitterkonstante von einkristallinem SiGe größer ist als die von einkristallinem Si. Eine Schichtdicke bezeichnet man als unterkritisch, wenn die aus verschiedenen Halbleitermaterialien bestehenden Schichten in lateraler Richtung die gleiche Gitterkonstante besitzen. Es liegt dann ein pseudomorphes Wachstum vor. Die Druckspannung bewirkt eine Stauchung der SiGe-Schicht bis zu 4%. Die durch das pseudomorphe Wachstum entstandene mechanische Spannung führt zu einer Reduzierung des Bandabstandes von SiGe und bewirkt eine zusätzliche Senkung der Ionisationsschwellenenergie von SiGe.

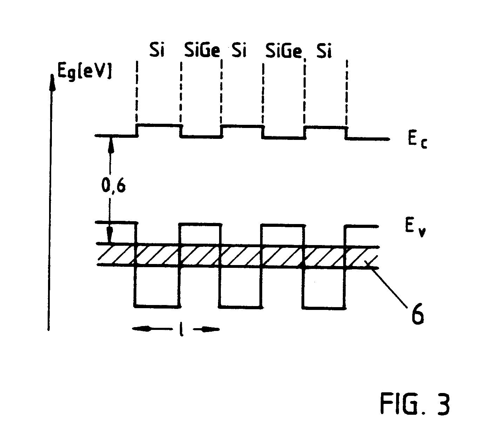

Zur Erhöhung des Wirkungsgrades der gattungsgemäßen IMPATT-Diode ist es außerdem vorteilhaft, die Generationszone als undotiertes Si/SiGe-Übergitter auszubilden. In einem Si/SiGe-Übergitter mit geeigneter Periodenlänge kann bei gleicher Schichtdicke wie für eine SiGe-Einzelschicht, der Ge-Anteil x in den Si₁₋ₓGeₓ-Schichten des Übergitters größer gewählt werden als in einer entsprechenden Si₁₋ₓGeₓ-Einzelschicht. Durch die Erhöhung des Ge-Anteils x der Si₁₋ₓGeₓ-Schichten und durch optimale Gestaltung der Periodenlänge des Si/SiGe-Übergitters läßt sich ein Miniband 6 im Energiebandschema des Si/SiGe-Übergitters (FIG. 3) erzeugen, dessen Bandabstand zum Leitungsband E_{c} kleiner ist als der Bandabstand zwischen Valenz- und Leitungsband einer SiGe-Einzelschicht mit gleicher Schichtdicke. Beispielsweise betragen für eine Si_{1-x'}Ge_{x'}-Einzelschicht mit einer Schichtdicke von 0,02µm der maximale Ge-Anteil x' = O,4 und der entsprechende Bandabstand E_{g} = 0,76eV. Für ein symmetrisches Si/Si₁₋ₓGeₓ-Übergitter mit einer Schichtdicke von 0,02µm, das aus einer Anzahl von fünf Perioden mit der Periodenlänge 1 = 0,004µm aufgebaut ist, betragen der maximale Ge-Anteil x = 0,8 und der entsprechende Bandabstand E_{g} = 0,6 eV (FIG. 3). Bei einem symmetrischen Übergitter haben alle Einzelschichten des Übergitters die gleiche Schichtdicke.

Die kritische Schichtdicke des Si/Si₁₋ₓGeₓ-Übergitters ist bei gleichem Ge-Anteil x größer als bei einer Si₁₋ₓGeₓ-Einzelschicht. Dadurch kann die Schichtdicke der Generationszone bei Verwendung einer Si/SiGe-Übergitters größer gewählt werden als für eine SiGe-Einzelschicht. Das hat den Vorteil, daß die Übergitter-IMPATT-Diode über einen weiteren Frequenzbereich einsetzbar ist als die entsprechende Heterostruktur-IMPATT-Diode mit lediglich einer SiGe-Schicht.

Im Ausführungsbeispiel gemäß FIG. 2 ist eine IMPATT-Diode mit einer Doppel-Heterostruktur angegeben. Die Doppel-Heterostruktur unterscheidet sich beispielsweise von der Einfach-Heterostruktur (FIG. 1) durch eine weitere p-dotierte Si-Schicht 5, die zwischen p⁺-dotiertem Substrat 1 und undotiertem Si/Si₁₋ₓGeₓ-Übergitter 2 aufgewachsen ist (FIG. 2). Die Si-Schicht 5 besitzt eine Schichtdicke von ungefähr 0,25µm und eine positive Ladungsträgerkonzentration von etwa 1,6 ^{.} 10¹⁷cm⁻³. Das Substrat 1 und die Halbleiterschichten 2, 3, 4 sind bezüglich der Schichtdicke und Schichtzusammensetzung analog Ausführungsbeispiel 1 gewählt.

Die höhere Ionisationsrate eines Si/Si₁₋ₓGeₓ-Übergitters hat den Vorteil, daß der räumliche Bereich, in dem Verlustleistung auftritt, verkleinert wird und der Wirkungsgrad der IMPATT-Diode vergrößert wird. Der Wirkungsgrad der Heterostruktur-IMPATT-Dioden gemäß der Erfindung liegt für eine Frequenz von 100GHz zwischen 12 bis 15%.

Der Wellenlängenbereich der erfindungsgemäßen IMPATT-Dioden liegt im mm- und sub-mm-Bereich.

Die Heterostruktur-Halbeiterschichtenfolgen der erfindungsgemäßen IMPATT-Dioden wird mit dem Molekularstrahl-Epitaxie-Verfahren erzeugt.

Die Erfindung ist nicht auf die angegebene p⁺inn⁺- oder p⁺pinn⁺-Struktur der IMPATT-Dioden beschränkt, sondern sie ist auch auf die inversen Strukturen anwendbar, die dadurch entstehen, daß in den Ausführungsbeispielen der Leitungstyp der Halbleiterschichten vertauscht wird (n-Leitung wird durch p-Leitung ersetzt und umgekehrt). Weiterhin sind nicht nur die angegebenen Quasi-Read-Strukturen für die erfindungsgemäßen IMPATT-Dioden geeignet, sondern die Erfindung ist auch für Misawa-Dioden anwendbar.

## Patentansprüche

1. IMPATT-Diode aus einem einkristallinen Si-Substrat (1), auf dem eine Heterostruktur-Halbleiterschichtenfolge aufgewachsen ist, die eine alternierende Anordnung von mindestens zwei unterschiedlichen Halbleiterschichten besitzt, die zumindest einen Heteroübergang bilden, wobei das Halbleitermaterial mit dem niedrigeren Bandabstand die Generationszone definiert, dadurch gekennzeichnet,
- daß die Generationszone der IMPATT-Diode aus einem undotierten Si/Si₁₋ₓGeₓ-Übergitter (2) besteht,
- daß die Si₁₋ₓGeₓ-Schichten des Übergitters einen Ge-Anteil x besitzen der größer ist als in einer Si_{1-x'}Ge_{x'}-Einzelschicht mit einer unterkritischer Schichtdicke, die gleich der Gesamtdicke des Übergitters ist,
- daß die Si- und Si₁₋ₓGeₓ-Schichten des Übergitters eine Periodenlänge besitzen, derart, daß das Energiebandschema des Übergitters ein Miniband enthält, dessen Bandabstand zum Leitungsband kleiner ist als der Bandabstand zwischen Valenz- und Leitungsband einer Si_{1-x'}Ge_{x'}-Einzelschicht mit einer unterkritischen Schichtdicke, die gleich der Gesamtdicke des Übergitters ist.

2. IMPATT-Diode nach Anspruch 1, dadurch gekennzeichnet,
- daß das Si/Si₁₋ₓGeₓ-Übergitter fünf Perioden von Si- und SiGe-Schichten der Periodenlänge 1 = 0,004µm besitzt und die Gesamtdicke des Übergitters 0,02µm beträgt,
- daß die Einzelschichten des Übergitters gleiche Schichtdicke besitzen, und
- daß die Si₁₋ₓGeₓ-Schichten einen Ge-Anteil von x = 0,8 besitzen.

3. IMPATT-Diode nach Anspruch 1 oder 2, dadurch gekennzeichnet, daß auf dem p⁺-Si-Substrat (1) eine Heterostruktur-Halbleiterschichtenfolge aus
- einem undotierten Si/Si₁₋ₓGeₓ-Übergitter (2)
- einer n-dotierten Si-Schicht (3)
- einer n⁺-dotierten Si-Schicht (4)
aufgewachsen ist.

4. IMPATT-Diode nach Anspruch 1 oder 2, dadurch gekennzeichnet, daß auf dem p⁺-Si-Substrat (1) eine Heterostruktur-Halbleiterschichtenfolge aus
- einer p-dotieren Si-Schicht (5)
- einem undotierten Si/Si₁₋ₓGeₓ-Übergitter (2),
- einer n-dotierten Si-Schicht (3),
- einer n⁺-dotierten Si-Schicht (4)
aufgewachsen ist.

5. IMPATT-Diode nach einem der vorhergehenden Ansprüche, dadurch gekennzeichnet, daß bei der Heterostruktur-Halbleiterschichtenfolge jeweils der Leitungstyp der entsprechenden Halbleiterschichten invertiert ist.

## Claims

1. IMPATT diode of a monocrystalline silicon substrate (1), on which a heterostructure of semiconductor superimposed layers is grown, which possesses an alternating arrangement of at least two different semiconductor layers, which form at least one heterotransition, wherein the semiconductor material with the lower energy gap defines the generation zone, characterised thereby
- that the generation zone of the IMPATT diode consists of an undoped Si/Si₁₋ₓGeₓ transition lattice (2),
- that the Si₁₋ₓGeₓ layers of the transition lattice possess a Ge component x which is larger than in a Si_{1-x'}Ge_{x'} single layer with a subcritical layer thickness which is equal to the overall thickness of the transition lattice, and
- that the Si and Si₁₋ₓGeₓ layers of the transition lattice possess a period length such that the energy band pattern of the transition lattice contains a miniband of which the energy gap at the conductive band is smaller than the energy gap between valence and conductive band of a Si_{1-x'} Ge_{x'} individual layer with a subcritical layer thickness which is equal to the overall thickness of the transition layer.

2. IMPATT diode according to claim 1, characterised thereby
- that the Si/Si₁₋ₓGeₓ transition lattice possesses five periods of Si and SiGe layers of the period length 1 = 0.004 µm and the overall thickness of the transition lattice amounts to 0.02 µm,
- that the individuall layers of the transition lattice possess the same layer thickness, and
- that the Si₁₋ₓGeₓ layers possess a Ge component of x = 0.8.

3. IMPATT diode according to claim 1 or 2, characterised thereby that a heterostructure of semiconductor superimposed layers is grown on the p⁺-Si substrate (1) from
- an undoped Si/Si₁₋ₓGeₓ transition lattice (2),
- and n-doped Si layer (3), and
- an n⁺-doped Si layer (4).

4. IMPATT diode according to claim 1 or 2, characterised thereby that a heterostructure of semiconductor superimposed layers is grown on the p⁺-Si substrate (1) from
- a p-doped Si layer (5),
- an undoped Si/Si₁₋ₓGeₓ transition lattice (2),
- an n-doped Si layer (3), and
- an n+-doped Si layer (4).

5. IMPATT diode according to one of the preceding claims, characterised thereby that in the case of the heterostructure of semiconductor superimposed layers each time the conductive type of the corresponding semiconductor layers is inverted.

## Revendications

1. Diode IMPATT, diode à avalanche à effet de temps de transit, constituée d'un substrat Si monocristallin (1) sur lequel on fait croître une succession de couches semi-conductrices à hétérostructure , succession qui présente une disposition alternée d'au moins deux couches semi-conductrices différentes qui forment au moins une hétérojonction, étant précisé que c'est le matériau semi-conducteur présentant la plus petite bande interdite qui définit la zone de génération, diode caractérisée
- par le fait que la zone de génération de la diode IMPATT est constituée d'une surstructure SI/Si₁₋ₓGeₓ (2) non dopée,
- par le fait que les couches Si₁₋ₓGeₓ de la surstructure comportent une proportion x de Ge qui est plus grande que dans une couche individuelle Si_{1-x'}Ge_{x'} présentant une épaisseur de couche sous critique égale à l'épaisseur totale de la surstructure,
- par le fait que les couches Si et et Si₁₋ₓGeₓ de la surstructure possèdent une longueur de période telle que le schéma des bandes d'énergie de la surstructure contient une minibande dont la bande interdite jusqu'à la bande de conduction est plus petite que la bande interdite entre la bande de valence et la bande de conduction d'une couche individuelle Si_{1-x'}Ge_{x'} à épaisseur de couche sous critique qui soit égale à l'épaisseur totale de la surstructure.

2. Diode IMPATT selon la revendication 1, caractérisée
- par le fait que la surstructure Si/Si₁₋ₓGeₓ possède cinq périodes de couches Si et SiGe de longueur de période 1 = 0,00 µm et que l'épaisseur totale de la surstructure vaut 0,02 µm,
- par le fait que les couches individuelles de la surstructure présentent une même épaisseur de couche et
- par le fait que les couches individuelles possèdent une proportion de Ge égale à x = 0,8.

3. Diode IMPATT selon la revendication 1 ou 2, caractérisée par le fait que sur le substrat Si-p⁺ (1) on fait croître une succession de couches semi-conductrices à hétérostructure constituée de
- une surstructure Si/Si₁₋ₓGeₓ (2) non dopée
- une couche Si (3) dopée en type n
- une couche Si (4) dopée en type N⁺.

4. Diode IMPATT selon la revendication 1 ou 2, caractérisée par le fait que sur le substrat Si-p⁺ (1) on fait croître une succession de couches semi-conductrices à hétérostructure constituée de
- une couche Si (5) dopée en type p
- une surstructure Si/Si₋₁ₓGeₓ (2) non dopée,
- une couche Si (3) dopée en type n,
- une couche Si (4) dopée en type n⁺.

5. Diode IMPATT selon l'une des revendications précédentes, caractérisée par le fait que dans le cas de la succession de couches semi-conductrices à hétérostructure, le type de conduction des couches semi-conductrices correspondantes est chaque fois inversé.
